Europäisches Patentamt

European Patent Office

Office européen des brevets

(11) Publication number: **0 061 859**
**B1**

(12) **EUROPEAN PATENT SPECIFICATION**

(45) Date of publication of patent specification: **18.06.86**

(21) Application number: **82301308.1**

(22) Date of filing: **15.03.82**

(51) Int. Cl.⁴: **H 01 L 27/10**

(54) Semiconductor memory device.

(30) Priority: **24.03.81 JP 42692/81**

(43) Date of publication of application:
**06.10.82 Bulletin 82/40**

(45) Publication of the grant of the patent:
**18.06.86 Bulletin 86/25**

(84) Designated Contracting States:
**DE FR GB NL**

(56) References cited:
**US-A-4 000 504**
**US-A-4 064 491**

(73) Proprietor: **FUJITSU LIMITED**
**1015, Kamikodanaka Nakahara-ku**
**Kawasaki-shi Kanagawa 211 (JP)**

(72) Inventor: **Taguchi, Masao**
**4-3-4-201, Araisono**
**Sagamihara-shi Kanagawa 228 (JP)**

(74) Representative: **Allman, Peter John et al**
**Marks and Clerk Suite 301 Sunlight House Quay Street**
**Manchester M3 3JY (GB)**

Courier Press, Leamington Spa, England.

EP 0 061 859 B1

## Description

### Background of the invention

#### (1) Field of the invention

The present invention relates to a semiconductor memory device, more particularly, to a novel semiconductor memory device which can be very densely integrated and which is suited for constructing a dynamic random access memory device.

#### (2) Description of the prior art

A dynamic random access memory (RAM) device which can be very densely integrated has hitherto consisted of a memory device of the one transistor cell type, i.e., the memory cell has hitherto consisted of a single metal-oxide semiconductor (MOS) transistor and a single storage capacitor. A memory cell of this type, however, is not necessarily advantageous when it is attempted to further increase the degree of integration. That is, a memory cell of this type stores data in the form of electric charges in the capacitor, and the readout of the data is effected by directly detecting the presence or absence of electric charges in the form of a change in the potential of a bit line or a digit line. Therefore, according to the increase in the degree of integration, the change in the potential of the bit line becomes very small when the readout is effected and may often become too small to be detected by a sense amplifier. The magnitude of the change in the potential of the bit line depends on the ratio of the stray capacitance of the bit line to the capacitance of the storage capacitor. However, the number of cells connected to a single bit line increases along with the increase in degree of integration. The stray capacitance therefore increases, while the capacitance of each of the storage capacitors decreases, because of the small size, thereof. Therefore, in a memory device of the type having a single-transistor cell, there is an essential difficulty in detecting the change in the potential when the degree of integration is large.

On the other hand, in a conventional memory device having conventional three-transistor-type cells, each of the memory cells itself functions to produce an amplified signal indicating the presence or absence of electric charges stored in the memory cell. Therefore, no problem exists in regard to the readout of data even when the memory cells are very densely integrated. However, since each of memory cells of this type has three independent MOS transistors, a memory device having such memory cells is basically not suited for very dense integration.

US—A—4 000 504 discloses a semiconductor charge storage and detection device comprising a substrate in which an ion-implanted conductive channel 13 is buried between source and drain regions 15, 17. A charge storage region 19 extends between the conductive channel 13 and the surface of the semiconductor device. The charge storage region is isolated from the semiconductor substrate and may be depleted of charge or enabled to store charge depending upon the potential applied to a gate electrode 23. The amount of charge stored is detected by sensing the conductance of the channel. The device has a gate insulator of uniform thickness, and the channel region located beneath the gate electrode is not isolated from the substrate.

US—A—4 064 491 describes an information memory comprising gate insulators having different thicknesses.

### Summary of the invention

It is an object of the present invention to provide a memory device which is suitable for very dense integration.

According to the present invention, there is provided a semiconductor memory device which includes memory cells each comprising a semiconductor substrate having one type of conductivity; a region having an opposite type of conductivity formed on the surface portion of said semiconductor substrate; a means for detecting conductance of said region having the opposite type of conductivity; a depletion-type channel region of said one type of conductivity formed on said region having the opposite type of conductivity; a gate insulator which is formed on the surface of said channel region; and a gate electrode formed on said gate insulator; a portion of said gate insulator having a reduced thickness, and the portion of said channel region under the reduced thickness portion of said gate insulator being adjoined by said region having the opposite type of conductivity on one side and being laterally surrounded by the remaining portions of said channel region in said semiconductor substrate.

### Brief description of the drawings

Figure 1 is a cross-sectional view illustrating the fundamental setup of a memory cell used in a memory device according to the present invention;

Fig. 2 is a graph illustrating the substrate bias effect of the two transistors in the memory cell of Fig. 1;

Figs. 3A through 3H are sectional views illustrating the spread of the depletion layer when the gate voltage and the substrate bias are changed;

Figs. 4 through 6 are a perspective view and two sectional views, respectively, illustrating the construction of the memory cell as an embodiment of the present invention;

Fig. 7 is a circuit diagram illustrating an equivalent circuit of the memory cell illustrated in Figs. 4 through 6;

Figs. 8A through 8F are sectional views illustrating the spread of the depletion layer in the memory cell illustrated in Figs. 4 through 6;

Fig. 9 is a circuit diagram illustrating a memory device according to the present invention which includes a memory cell of Fig. 7;

Fig. 10 is a timing diagram illustrating the operation of the memory device of Fig. 9; and

Fig. 11 is a sectional view illustrating another construction of a memory cell used in a memory device as another embodiment of the present invention.

Description of the preferred embodiments

The fundamental setup, principle of operation, and a preferred embodiment of the semiconductor memory device of the present invention will now be explained in detail with reference to the drawings.

For all intents and purposes, each of the memory cells of the above-mentioned semiconductor memory device according to the present invention can be regarded as being constructed in such a manner that two depletion-type metal-insulator semiconductor (MIS) (or MOS) field effect transistors having gate insulator of different thickness are coupled in series with their channel regions being directly coupled to each other without interposition of a source or drain region having a high impurity concentration. The present invention utilizes the difference in the substrate body effect (or backgate effect) of the two MIS transistors and utilizes the transient phenomenon, in which the channel of one of the MIS transistors is confined in a condition which is out of thermal equilibrium by selecting the biasing condition of another MIS transistor, to accomplish operation of the memory element.

The MIS transistor usually comprises a gate of MIS construction, source and drain regions of high impurity concentrations, a channel, and a substrate. The channel may be an inversion layer or may be a region having a conductivity opposite in type to that of the substrate which region is formed on the interface of the MIS construction.

The threshold voltage of the MIS transistor, i.e., the gate voltage $V_T$ with respect to the source when a conductive path between the drain and the source is formed, is as follows:

$$V_T = V_{FB} + 2\phi_B + \frac{1}{C_i}\sqrt{2\varepsilon_s q N_A(2\phi_B)} \qquad (1)$$

(see "Physics of Semiconductor Device", by S. M. Sze, p. 524 published by John Wiley & Sons, N.Y.), where $V_{FB}$ denotes a flat-band voltage of a diode of MIS structure and is determined by the electrode material, the thickness of the gate insulator, and the like. $\phi_B$ denotes a Fermi level on the basis of an intrinsic level in the bulk of the semiconductor substrate, and $C_i$ denotes the capacitance of the gate insulator per unit area. $\varepsilon_s$ denotes the dielectric constant of the semiconductor substrate, and $N_A$ denotes the impurity-doping concentration. The third term in the equation (1) stems from the electric charges in the depletion layer established between the channel and the substrate. If the source potential is not equal to the substrate bias, i.e., the substrate potential, and if only the bias voltage $V_{sub}$ is applied to the substrate, the equation (1) can be written as follows:

$$V_T = V_{FB} + 2\phi_B + \frac{1}{C_i}\sqrt{2\varepsilon_s q N_A(2\phi_B + V_{sub})} \qquad (2)$$

From the equation (2), the threshold potential $V_T$ increases according to the increase in the bias voltage $V_{sub}$. Further, the effect of the substrate bias potential, i.e., the body effect becomes more remarkable with an increase in $N_A$ and with a decrease in $C_i$, i.e., with an increase in the thickness of the gate insulator. If MIS transistors of, for example, the n-channel type, having different $C_i$ values are formed on the same semiconductor substrate, the threshold voltage $V_T$ relative to the source bias voltage changes as mentioned below. That is, an MIS transistor having a small $C_i$ value exhibits a remarkably increased threshold value with an increase in the substrate bias potential, which is negative with respect to the source. In other words, when the $C_i$ value is small or when the thickness of the gate insulator is large or the dielectric constant thereof is small, a large threshold potential is always exhibited when $V_{sub}=0$, owing to the effect of the third term of the equation (2). The threshold potential value is further increased by the substrate bias effect. If impurities are introduced into the channel portion in order to control the threshold voltage, a term which is dependent on $C_i$ is added to $V_{FB}$ of the equation (2) so that:

$$V_T = V_{FB} - \frac{q N_c}{C_i} + 2\phi_B + \frac{1}{C_i}\sqrt{2\varepsilon_s q N_A(2\phi_B + V_{sub})} \qquad (3)$$

where $N_c$ denotes the dosage of ions implanted at the channel portion in order to change the threshold voltage. The implanted ions will provide a conductivity opposite to that of the substrate. In this case, the threshold voltage $V_T$ assumes either a positive value or a negative value, depending on the significance of the second term and the fourth term of the equation (3), while changing the substrate bias voltage $V_{sub}$. In an MIS transistor having a small $C_i$ value, the influence of the fourth term is large and the above-mentioned tendency is very pronounced.

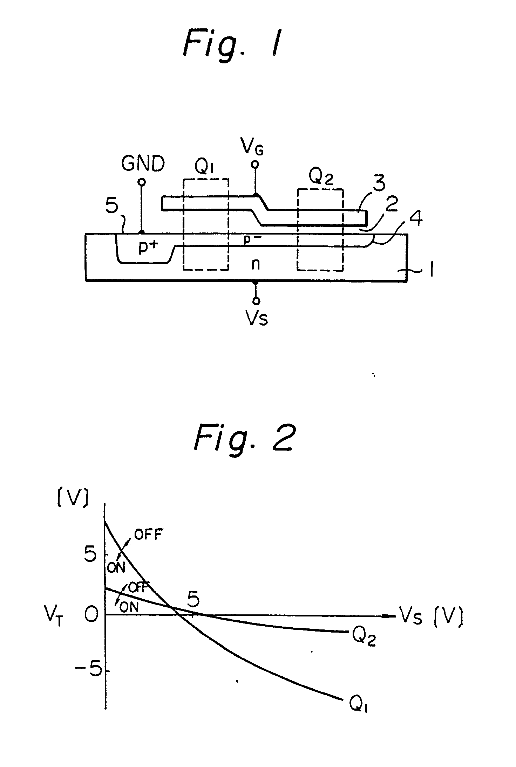

Taking the above-mentioned facts into consideration, the operations of the two MIS transistors in the memory element of the present invention will now be explained. Figure 1 illustrates a fundamental setup of two depletion-type, p-channel MIS transistors Q1 and Q2 having gate insulator 2 of different thickness on an n-type substrate 1 but having a common gate electrode 3. Figure 2 shows the dependency of the threshold voltages of the two transistors Q1 and Q2 with respect to the substrate potential $V_S$. The transistor Q1 having a thick gate insulator exhibits a high threshold voltage at $V_S=0$, which, however, changes drastically in accordance with the change in the substrate potential $V_S$ due to the body effect. In the transistor Q2 having a thin gate insulator, the body effect is small. Therefore, the two characteristics curves intersect.

The present invention utilizes this phenomenon. When the impurity concentration in the substrate is about $10^{16}$ cm$^{-3}$, the thickness of the thicker portion of the gate insulator 2 of the transistors Q1 and Q2 should be at least 10 times greater than that of the thin portion thereof so as to obtain the above-mentioned characteristics. For example, when the gate insulator 2 corresponding to the portion of the transistor Q1 is made of $SiO_2$ and has a thickness of 400 nm (4000 angstroms), the thickness of the gate insulator 2 corresponding to the portion of the transistor Q2 should be smaller than 400 nm (400 angstroms).

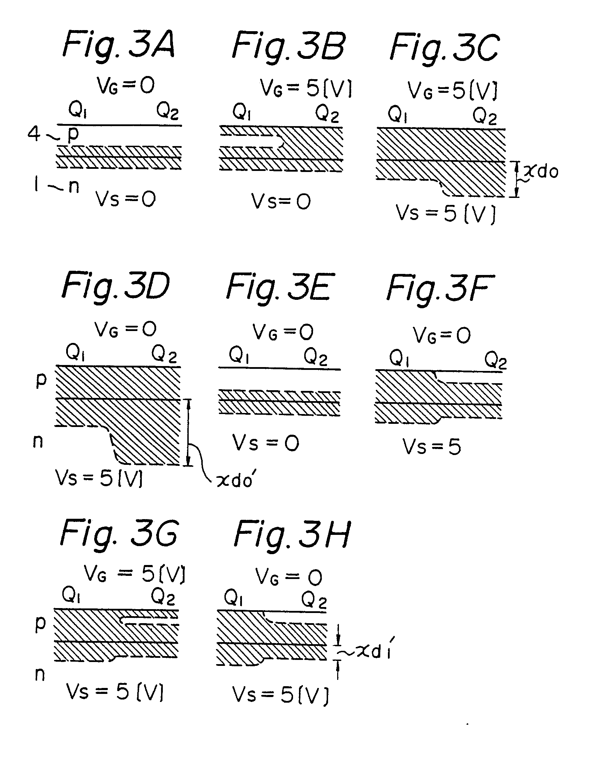

Figure 3 shows the thickness of the depletion layer (hatched portions) established in the substrate when a power supply voltage of 5V is supplied to the device of Fig. 1 and when a gate voltage $V_G$ and a substrate voltage $V_S$ can be varied from 0 volt to 5 volts. For simplification of the diagram, Fig. 3 shows neither the gate electrode 3 nor the high concentration region 5 that serves as a source or drain. However, these are the same as those of Fig. 1, and the high concentration region 5 is grounded. Figure 3A shows the state in which both the gate voltage $V_G$ and the substrate voltage $V_S$ are not applied. A p-channel region 4 whose conductivity is opposite to that of the substrate is formed on the surface of the substrate so that the transistors Q1 and Q2 will be of the depletion type. Depending on the properties of the gate electrode material or the quantity of the fixed electric charges included in the gate insulator, a p-type inversion layer may often be formed on the surface of the substrate simultaneously with the formation of the gate without implanting p-type impurities into the surface portion of the substrate. In either case, an electrically neutral and electrically conductive region is formed on the surface of the substrate 1, and a depletion region of pn junction is formed under this region into the surface portion of the substrate 1. In the drawings, the hatched portions represent depletion regions. Figure 3B shows a case in which the gate potential $V_G$ is increased to, for example, 5 volts. In the transistor Q1 having a thick gate insulator, a change in the potential $V_G$ has little effect on the channel 4, therefore, a neutral or electrically conductive area still remains in the channel region 4, and the channel region 4 is still in a turned on condition. The depletion layer, however, has been formed on the surface of the substrate due to the effect of the gate voltage $V_G$. In the transistor Q2 having a relatively thin gate insulator, on the other hand, the channel 4 is completely depleted and is electrically non-conductive. Then, as shown in Fig. 3C, when the substrate voltage $V_S$ is increased to, for example, 5 volts, the transistor Q1 easily receives the substrate effect. Therefore, the threshold voltage changes greatly and the channel is easily depleted over the entire area.

The transistor Q2 slightly receives the substrate effect and the width of the depletion layer formed from the channel 4 toward the substrate 1 slightly increases to $x_{d0}$. Thus, when the substrate voltage $V_S$ is raised to render the transistor Q1 non-conductive due to the body effect, the transistor Q2 is not rendered conductive even when the gate voltage $V_G$ is lowered to 0 volt, as shown in Fig. 3D. This is because, in order that the transistor Q2 is turned on, the ionized acceptor region that serves as a channel must be neutralized by holes in such a way that an electrically conductive region is established. In practice, however, the transistor Q1 remains in a turned off condition and there is no source for injecting holes into the channel of the transistor Q2. This stems from the fact that the transistor Q2 does not have a p$^+$-type high concentration region serving as a source or drain. Therefore, when the gate voltage $V_G$ is lowered, the width of the depletion layer which stretches from beneath the gate of the transistor Q1 to the substrate 1 further stretches to ionize the gate of the n-type region 1 on the side of the substrate to satisfy the requirement for neutralizing the electric charge. In this case, the portion beneath the gate of the transistor Q2 assumes a so-called deep depletion condition in the MOS construction and remains in a thermally non-equilibrium state. The width of the depletion layer in the n-type region is denoted by $x_{d0}'$.

On the other hand, the device of Fig. 1 operates in a different manner when the substrate voltage $V_S$ is raised first while maintaining the gate voltage $V_G$ at 0 volt. Figure 3E illustrates the same condition as that of Fig. 3A in which both the gate voltage $V_G$ and the substrate voltage $V_S$ are 0 volt. Next, if $V_S$ is raised to, for example, 5 volts while maintaining $V_G$ at 0 volt, as shown in Fig. 3F, the transistor Q1 is easily rendered non-conductive because the transistor Q1 receives the remarkable effect of the bias potential of the substrate. In the transistor Q2, on the other hand, the body effect is small, and the transistor Q2 is in a turned on condition although the width of the depletion layer widens in the p-type region in the channel and in the n-type region in the substrate. Figure 3G shows the state in which $V_G$ is raised to, for example, 5 volts. In the transistor Q1, the channel has already been depleted and, therefore, a rise in $V_G$ causes the depletion layer in the substrate to grow very little. In the transistor Q2, the depletion layer is formed in the surface portion of the channel according to a rise in the gate voltage, and the neutral channel region is surrounded by the depletion layer and is kept in a floating condition. Therefore, as shown in Fig. 3H, if $V_G$ again falls to 0 volt, a state which is quite the same as that of Fig. 3F is established.

A comparison of the states of Fig. 3C and Fig. 3G and a comparison of the states of Fig. 3D and Fig. 3H, which are under the same bias conditions, indicate that the widths of the depletion layers formed in the n-type region 1 of the substrate of the transistor Q2 are different. In the states of Fig. 3C and Fig. 3D, the depletion layer is excessively spread under a thermally non-equilibrium state. Owing to the carrier generation in the depletion layer and the punch-through effect of the transistor Q1, holes are injected into the channel and the thermally non-equilibrium state of Fig. 3D shifts toward the thermally equilibrium state of Fig. 3H. In this case, the length of time for which the thermally non-equilibrium state is maintained is as long as is necessary for utilization of the memory elements of the dynamic RAM.

The present invention utilizes two states which are transiently different in regard to the width of the depletion layer under the same bias conditions. In the present invention, conditions in which the width of the depletion layer is large and small correspond respectively to the data 0 and 1, and the width is detected from the external side.

The method of detecting the width of the depletion layer in the transistor Q2 consists, for example, of directly detecting the capacitance between the gate and the substrate. In this case, the situation becomes the same as when a general dynamic RAM having one-transistor, one-capacitor type memory cells is used. In such a dynamic RAM, the signal voltage from the memory cell is divided by the parasitic capacitance of the bit line and the cell capacitances, so that it is essentially difficult to obtain detection signals of large levels. On the other hand, if the thickness of the n-type region that serves as a substrate in Figs. 3A through 3H is selected as a finite value and if an electric current is allowed to flow through the region in the direction parallel to the boundary plane between the p-type region 4 and the n-type region 1, so that the width of the depletion layer just beneath the gate of the transistor Q2 can be detected on the basis of the conductance value of the region, it is possible that the memory cell itself will have a current gain relative to the stored electric charge or the width of the depletion layer and that the output voltage will be increased.

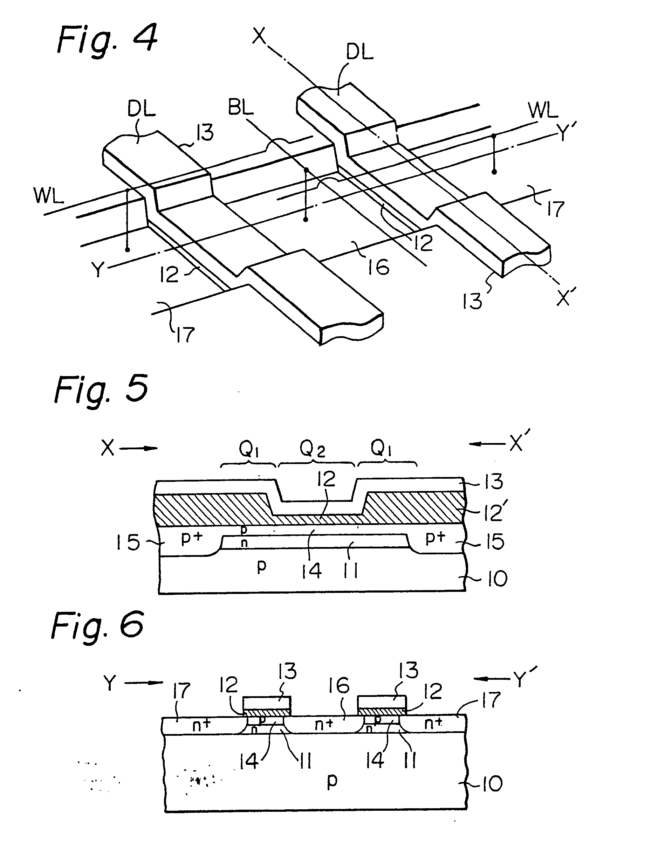

Figure 4 is a perspective view illustrating a concrete structure of the major portions of a memory cell used in a memory device according to the present invention. The memory cell of Fig. 4 uses a p-type substrate. The n-type region 1, which is assumed to serve as the substrate in the structure of Fig. 1, is constructed as a layer that is buried in the p-type substrate.

Figure 5 is a sectional view taken on line X—X' of the element of Fig. 4, in which the transistors Q1 are formed on both sides of the transistor Q2 so that the memory data can be stored more reliably. The substrate 10 is of the p-type, is electrically connected to the $p^+$-type regions 15 that serve as a source region and a drain region of the transistors Q1, and is maintained at ground potential. Figure 6 is a cross-sectional view of the element of Fig. 4 seen from a different angle (cross-sectional view along the line Y—Y' of Fig. 4). In Fig. 6, the n-type regions 16 and 17 of high impurity concentration, that serve as a source region and a drain region for the gate electrode (data line DL) 13 composed of polycrystalline silicon or the like, are connected to a bit line BL and to a word line WL, respectively. Further, the regions 16 and 17 are in ohmic-contact with the buried n-type layer 11 in the portion of the transistor Q2. Control of the voltage applied to the n-type regions 11, 16, 17 corresponds to control of the substrate bias voltage $V_S$ applied to the n-type substrate of Fig. 3.

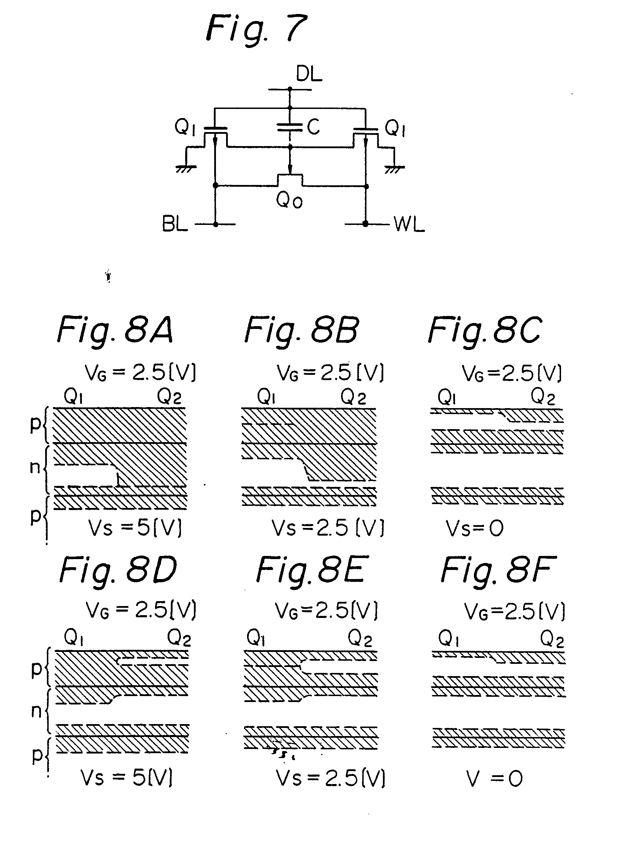

Figures 4 and 6 illustrate a pair of memory cells disposed on both sides of a bit line BL. Figure 7 illustrates an equivalent circuit of a single memory cell. In the equivalent circuit of Fig. 7, the transistor Q2 having a thin gate insulation film 12 is represented here as a capacitor C, and a junction-type transistor Q0 with a channel region 14 as a gate region is provided just under the capacitor C. The channel region of the junction-type transistor Q0 consists of an n-type buried layer 11 so as to secure the current gain when the data is to be read out.

In the foregoing was mentioned the concrete setup of a memory cell used in a memory device according to the present invention. The arrangement of the bit line, word line, or data line can be variously modified. In effect, the depletion-type channel region of transistor Q2 (p-type region 14 beneath the transistor Q1) should be completely surrounded by a region having an opposite type of conductivity (the n-type region 11 in the above-mentioned example) and by the remaining portion of the channel region so that it is isolated from the region (the $p^+$-type region 15 and the substrate 10 in the above example) which serves as the source of the injecting carriers (holes) and so that the thermally non-equilibrium state will last for a sufficiently long period of time. A current gain can be obtained when the data is to be read if a junction-type field-effect transistor (FET) is equivalently formed beneath the channel region. Therefore, the memory cell produces signals of a sufficiently large amplitude even when it is constructed in a small size.

The operation of the memory cell used in the embodiment of the present invention shown in Figs. 4 through 7 will now be described.

As mentioned above with reference to Fig. 3, the data is written into the memory cell by establishing two states having depletion layers of different widths in the n-type region 11 by changing the order of varying the voltage $V_G$ applied to the gate electrode (data line) 13 and the voltage $V_S$ applied to the n-type region 11. If the thermally non-equilibrium state obtained by changing $V_G$ and $V_S$ in the order of Figs. 3A through 3C corresponds to the writing of "0", the writing of "1" can correspond to the thermally equilibrium state that is obtained by changing $V_G$ and $V_S$ in the order of Fig. 3E through 3G. Once the data is written as shown in Fig. 3D or Fig. 3H, the data is kept stored even when $V_G$ is reduced to 0 volt. To attain high-speed operation by minimizing the potential change that is required for refreshing while storing the data, the potential of the gate electrode (data line) 13 should be set at near one-half the power supply voltage or somewhat higher, say, at 2.5 through 4 volts in the above-mentioned embodiment.

The fundamental operation of the memory cell when the data is to be read out from the stored state will now be described, in conjunction with Figs. 8A through 8F which illustrate the spread of the depletion layer when the data is to be read. Figure 8 is the same as Fig. 3 except that the pn junctions formed by the n-type regions 11 and the p-type substrates 10 are added.

When the data is stored, the gate voltage $V_G$ is set to a voltage between the data "0" and the data "1", i.e., for example, 4.0 volts. This voltage is determined by the individual cell design, i.e., by the threshold voltage of the buried channel region.

Figure 8A shows the state in which the data "0" is stored. The bit line (n⁺-type region 16) is charged to 5 volts and is then floated. Here, the word line (n⁺-type region 17) selected by the decoder is driven to gradually drop the voltage from the initial voltage of 5 volts. Then, $V_S$ of the transistors Q1 and Q2 drops mainly through the channel on the side where the word line is connected. When $V_S$ has dropped to about 2.5 volts, as shown in Fig. 8B, the p-type channel is formed as the substrate bias voltage of the transistor Q1 decreases, and holes are injected from the p-type region into the depletion layer of the transistor Q2. Therefore, practical read out operation is effected in a condition in which the holes are not yet injected and the potential of the word line is, for example, about 3.5 volts. As the holes are injected, the width of the depletion layer beneath the gate of the transistor Q2 shrinks. The transistor Q2 assumes the thermally equilibrium state as $V_S$ drops to 0 volt.

When the data "1" is stored, on the other hand, the potential $V_S$ is dropped from 5 volts under the condition of Fig. 8D. When the potential $V_S$ is decreased to, for example, 2.5 volts, the state shown in Fig. 8E is established. The state of Fig. 8F is established when $V_S$ is 0 volt. This the same as the condition when the data "0" is read out. Namely, the memory cell of the present invention pertains to the type in which the stored content is destroyed when the data is read out by driving the word lines in the above-mentioned manner. However, if Fig. 8B and Fig. 8E illustrating conditions under transient conditions before $V_S$ is completely dropped to 0 volt are compared each other, there is a difference in the widths of the depletion layers in the transistor Q2. In the condition of Fig. 8E in which the width of the depletion layer is narrow, a current flows from the bit line 16, which is precharged through the n-type buried conductive layer 11 beneath the gate of the transistor Q2, to the word line 17 so that the potential of the bit line drops. The potential $V_S$ drops with the decrease in the potential of the bit-line, and the width of the depletion layer is narrowed more quickly. In Fig. 8B, on the other hand, almost no current flows, and a difference develops in the potential of the bit-line. If the drop of the word line potential under a limited value, for example 3.5 volts, is inhibited when readout is effected, it is possible to effect readout without destroying the stored data. Like the conventional art, a sense amplifier is provided so as to amplify the voltage difference between the two bit lines. If a dummy cell is arranged so that either one of the bit lines assumes a bit line voltage of a level having a medium value between the data "0" and the data "1", the voltage difference produced on the bit line due to discharge of the cell transistor is latched by the sense amplifier before the stored data is destroyed by the readout of the data. After the cell data has been destroyed by the readout of the data, the data can be restored if it is rewritten through the sense amplifier.

In the memory device of the present invention, the electric charges precharged in the bit line are discharged through the junction-type FET in which the n-type layer 11 beneath the gate of the transistor Q2 serves as a channel. Unlike the conventional dynamic RAM cell made up of one transistor and one capacitor, therefore, the operation does not simply consist of temporarily charging electric charges in the capacitor or discharging electric charges from the capacitor. Namely, in the memory device of the present invention, a cell having a narrow depletion layer and an n-type neutral but conductive layer permits the electric current to flow continuously as long as there is a potential difference between the bit line and the selected word line. Therefore, the voltage change produced on the bit line on the readout operation is considerably greater than that of the conventional memory device. As a result, the sense amplifier requires less sensitivity than does conventionally employed sense amplifiers, and therefore, the design and manufacturing requirements can be simplified. Further, a great difference in the potentials of the bit lines means that the memory cell is not affected by disturbances such as irradiation with a particles or injection of hot electrons, which may result in erroneous operation.

Furthermore, unlike conventional cells, the memory cell of the present invention does not require a capacitor having large storing capacitance. The reason is because, in the conventional cell, the stored charge is distributed depending upon the capacitance of the memory cell and the parasitic capacitance of the wiring of the bit line and so on and is read as a change in the voltage of the bit line. Therefore, the capacitance of the capacitor has a direct relation to the output voltage. In the memory cell according to the present invention, on the other hand, the quantity of the stored electric charges is not read out, but, instead, the width of the depletion layer corresponding to the stored charges is detected as a channel current of the FET. Therefore, the area occupied by the memory cell per bit can be considerably reduced, although it may not be reduced so as to correspond to the absence of the capacitor.

Furthermore, the memory of the present invention can be realized with a single layer gate construction as shown in Figs. 4 through 6. In the conventional memory cell, a gate construction consisting of at least two layers was required to optimize the arrangement of cells and to minimize the useless areas. In the memory cell of the present invention, on the other hand, the bit lines are formed by using the same step and the same material used to form the data lines, and the bit lines are connected to the $n^+$-type regions by using the buried contact method. Therefore, the memory cell is constructed by simply forming a gate from a single polycrystalline silicon layer or a single metal wiring layer. To further increase the degree of integration, the word line and bit line should be formed of metal wirings of different layers. In this case, two metal wiring layers are formed, each consisting of a single layer of, for example, polycrystalline silicon.

An example of a sense amplifier for driving the memory cell of the present invention will now be described.

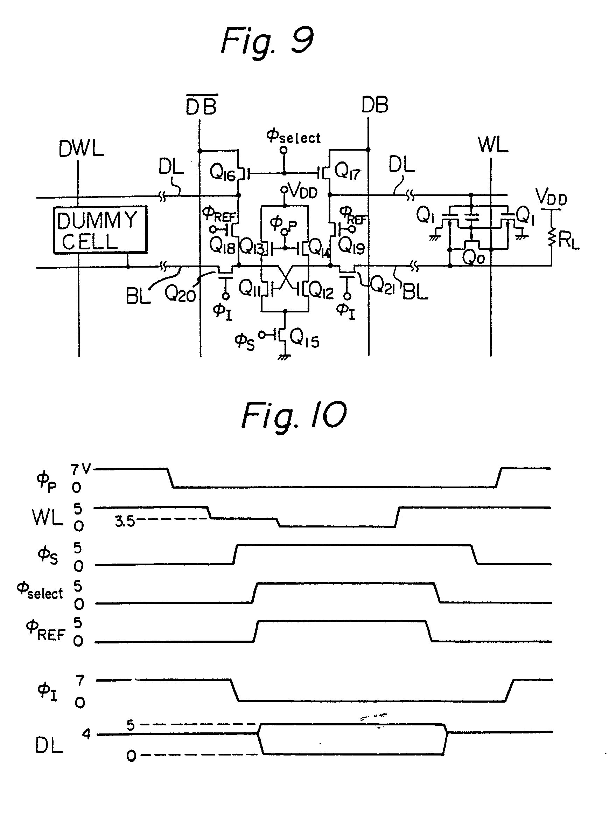

Figure 9 illustrates a circuit which is constructed based fundamentally upon a latch circuit that is employed for conventional memory devices, and Fig. 10 is a timing chart illustrating the operation thereof. Transistors Q11 and Q12 constitute a latch circuit, a pull-down transistor Q15 is connected to their common sources, and precharge transistors Q13 and Q14 connected to the bit line BL are driven by clock pulses $\phi_p$. Transistors Q16, Q17 connect the bit line to the common data bus DB and $\overline{DB}$ and are driven by the clock pulses $\phi_{select}$ produced by a column decoder. The above-mentioned portions operate in the same manner as the conventional one-transistor-type dynamic RAM sense amplifier. The sense amplifier of Fig. 9 further comprises transistors Q18 and Q19, which are turned on when refresh of the memory data is effect, and transistors Q20 and Q21, which disconnect the bit lines BL and the sense amplifier when readout is effect.

In the conventional memory device, the data is fed to the memory cell through the bit line. In the memory device of the present invention, on the other hand, the data is fed to the memory cell through a specially formed data line DL. To write the data onto the memory cell, transistors Q16, Q17 selected by the column decoder are rendered conductive to transfer the voltage of the data bus lines DB, $\overline{DB}$ to the data lines DL, and then the voltage of the word line WL selected by the row decoder is reduced to the ground level. In this case, the transistors Q13, Q14 are always turned on to pull the voltage of the bit lines BL up to the level $V_{DD}$ (for example, 5 volts) so that the current is supplied to the memory cell.

The data is usually read in a condition where the transistors Q13, Q14 are non-conductive and the bit lines BL are precharged to a high level. However, when the voltage of the bit line is drastically dropped by the sensing operation to a potential which is nearly equal to the word line potential (this develops when the impurity concentration in the n-type buried layer of the memory cell transistor is greater than an optimum value or when the n-type buried layer has such a large thickness that an excessive current flows through the transistor Q0), the sensing operation should be carried out by rendering the transistors Q13, Q14 conductive or by providing a special load transistor or capacitor to pull up the voltage level of the bit line. It is preferable to connect a load element such as a load resistor $R_L$ between the bit line BL and a power source $V_{DD}$ so that the voltage of the bit line BL is slightly higher than that of the word line WL. By using such a load element, it is possible to prevent a current from flowing from the word line WL toward the bit line BL, whose voltage is dropped by non-selected memory cells connected thereto.

In order to initiate the read out operation, the voltage of the word line WL selected by the row decoder and the voltage of the corresponding dummy word line DWL are dropped from a high potential, for example, 5 volts, of the data-storing state to a slightly lower voltage, for example, 3.5 volts, which is limited in a range higher than a voltage in which the transistor Q1 is turned on and the holes are injected to the channel thereof. A voltage difference developed between the bit lines BL corresponding to the stored data is transferred to the sense amplifier comprising the transistors Q11 through Q15. Then the transistors Q20 and Q21 are turned off so that the sense amplifier is disconnected from the bit lines BL, and the output voltage of the sense amplifier of the low potential side is pulled down to the ground level by the operation of the sense amplifier. The word line voltage is also pulled down to the ground level so that the write in to the memory cell can be done. Next, the clock pulse $\phi_{REF}$ is raised to render the transistors Q18 and Q19 conductive, and the amplifier output voltages of the sense amplifier are transferred to the data lines DL. Moreover, the word line voltage is raised to a value of the stored condition, and the voltage of the data line DL is also returned to a value of the stored condition, for example, 4.0 volts. The stored data of the memory cell destroyed by the readout operation is written again onto the memory cell, and the data is refreshed. The potential difference between the bit lines BL is transferred to the data buses $\overline{DB}$ and DB through the transistors Q16 and Q17 selected by the column decoder and is outputted via a buffer amplifier (not shown in the drawing).

In the memory device according to the present invention, the sense amplifier has the function of automatically refreshing the data after each readout operation. Therefore, the memory device according to the present invention can be treated in the same manner as that of the conventional dynamic RAM. Major differences may be that the word line WL is maintained at a high level when the data is stored and is maintained at a low level when it is being selected.

Further, the dummy cell can be a resistor having a resistance which lies midway between the channel resistances of the junction-type transistor Q0 in the memory cell when the data "1" and "0" are read out.

The transistor Q1 need not be limited to the fundamental type illustrated in the foregoing but may be of a diffusion self align (DSA) type, vertical MOS (V-MOS) type, or any other known type.

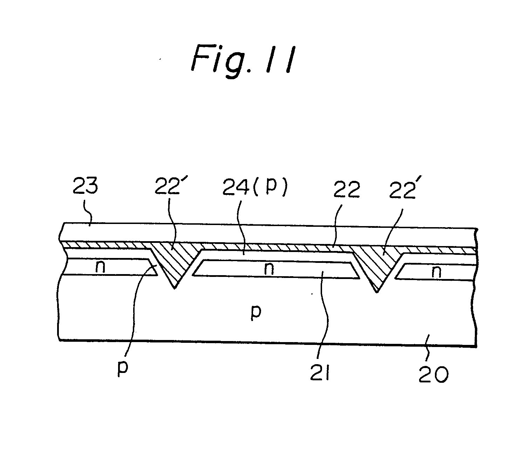

Figure 11 illustrates another example of a memory cell used in a memory device as another embodiment of the present invention. The memory cell of Fig. 11 is composed by using a V-MOS structure as the portions corresponding to the transistors Q1 of the foregoing structure of Figs. 4 through 6. The memory cell of Fig. 11 comprises a p-type substrate 20, n-type buried layers 21 formed on the substrate 21, p-type channel regions 24 formed on the n-type buried layers, a gate insulation film 22 of, for example, $SiO_2$, and a gate electrode 23 of, for example, aluminum. The gate insulator 22 has V-shaped thick portions 22' each of which corresponds to the thick gate insulation film portion 12' of the transistor Q1 illustrated in Fig. 5. A thin portion of the gate insulator 22 corresponds to the thin gate insulator portion 12 of the transistor Q2 of Fig. 5. Operation of the element of Fig. 11 is substantially the same as that of the foregoing example of Figs. 4 through 6, and the explanation thereof is omitted.

According to the present invention, as will be apparent from the above-mentioned embodiment, a sufficiently large output can be obtained from the memory cell when the data is to be read. Although three transistors per memory cell are required on an equivalent circuit, the construction of the memory cell is more suited for being highly integrated than are conventional one-transistor, one-capacitor-type cells and can be very effectively utilized for constructing a dynamic RAM in a highly integrated form.

**Claims**

1. A semiconductor memory device which includes memory cells each comprising a semiconductor substrate (10) having one type of conductivity; a region (11) having an opposite type of conductivity formed on the surface portion of said semiconductor substrate; a means for detecting conductance of said region having the opposite type of conductivity; a depletion-type channel region (14) of said one type of conductivity formed on said region (11) having the opposite type of conductivity; a gate insulator (12) which is formed on the surface of said channel region; and a gate electrode (13) formed on said gate insulator; a portion of said gate insulator (12) having a reduced thickness, and the portion of said channel region (14) under the reduced thickness portion of said gate insulator being adjoined by said region (11) having the opposite type of conductivity on one side and being laterally surrounded by the remaining portions of said channel region (14) in said semiconductor substrate.

2. A semiconductor memory device of claim 1, wherein the end portions of said channel region (14) are in contact with one or more regions (15) having said one type of conductivity and having a relatively high impurity concentration formed in said semiconductor substrate.

3. A semiconductor memory device of claim 1, wherein said channel region (14) is coupled to portions of said semiconductor substrate (10) having said one type of conductivity.

4. A semiconductor memory device of claim 1, wherein each of said memory cells comprises relatively high impurity concentration regions (16, 17) having said opposite type of conductivity which are formed on both sides of said region (11) having the opposite type of conductivity and which are in ohmic contact with said region (11) having the opposite type of conductivity.

5. A semiconductor memory device of claim 4, wherein one of said relatively high impurity concentration regions (16, 17) having said opposite type of conductivity is connected to a word line (WL) and another one of said high impurity concentration regions (16, 17) having said opposite type of conductivity is connected to a bit line (BL), said gate electrode (13) being connected to a data line (DL) through which the write in of data to the memory cell is effected.

**Patentansprüche**

1. Halbleiterspeicheranordnung mit:
Speicherzellen, die jeweils ein Halbleitersubstrat (10) von einem Leitfähigkeitstyp aufweisen;
einem Bereich (11), von entgegengesetztem Leitfähigkeitstyp, der auf dem Oberflächenabschnitt des genannten Halbleitersubstrats gebildet ist;
einer Einrichtung zum Lesen der Leitfähigkeit des genannten Bereiches, der vom entgegengesetzten Leitfähigkeitstyp ist;
einem Verarmungstyp - Kanalbereich (14), von dem genannten einen Leitfähigkeitstyp, der auf dem genannten Bereich (11) vom entgegengesetzten Leitfähigkeitstyp gebildet ist;
einem Gate-Isolator (12), der auf der Oberfläche des genannten Kanalbereiches gebildet ist;
une einer Gateelektrode (13) die auf dem genannten Gate-Isolator gebildet ist;
wobei ein Abschnitt des genannten Gate-Isolators (12) eine reduzierte Dicke hat und der Abschnitt des genannten Kanalbereichs (14) unter dem Abschnitt reduzierter Dicke des genannten Gate-Isolators an den genannten Bereich (11) von entgegengesetztem Leitfähigkeitstyp auf einer Seite angrenzt und seitlich von den verbleibenden Abschnitten des genannten Kanalbereichs (14) in dem genannten Halbleitersubstrat umgeben ist.

2. Halbleiterspeicheranordnung nach Anspruch 1, bei welcher die Endabschnitte des genannten Kanalbereichs (14) mit einem oder mehreren Bereichen (15), die in dem genannten Halbleitersubstrat ausgebildet sind, von dem genannten einen Leitfähigkeitstyp sind und eine relativ hohe Verunreinigungskonzentration haben, in Berührung stehen.

3. Halbleiterspeicheranordnung nach Anspruch 1, bei welchem der genannte Kanalbereich (14) an Abschnitte des Halbleitersubstrats (10) gekoppelt ist, welches von dem genannten einer Leitfähigkeitstyp ist.

4. Halbleiterspeicheranordnung nach Anspruch 1, bei welchem jede der genannten Speicherzellen Bereiche (16, 17) relativ hoher Verunreinig-ungskonzentration aufweist, die vom ent-gegengesetzten Leitfähigkeitstyp sind, die auf beiden Seiten des genannten Bereichs (11) gebildet sind, der von entgegengesetztem Leitfähigkeitstyp ist, und die in Ohmschem Kontakt mit dem genannten Bereich (11) stehen, der vom entgegengesetzten Leitfähigkeitstyp ist.

5. Halbleiterspeicheranordnung nach Anspruch 4, bei welcher einer der Bereiche (16, 17) mit relativ hoher Verunreinigungskonzentration, vom genannten entgegengesetzten Leitfähigkeitstyp, mit einer Wortleitung (WL) verbunden ist, und ein anderer der Bereiche (16, 17) hoher Verunreinig-ungskonzentration, vom entgegengesetzten Leit-fähigkeitstyp, mit einer Bitleitung (BL) verbunden ist, wobei die genannte Gateelektrode (13) mit einer Datenleitung (DL) verbunden ist, über welche das Einschreiben der Daten zu der Speicherzelle bewirkt sind.

**Revendications**

1. Dispositif à mémoire à semi-conducteurs qui comporte des cellules de mémoire, comprenant chacune un substrat semi-conducteur (10) ayant un premier type de conductivité; une région (11) ayant un type opposé de conductivité formée sur la partie de surface dudit substrat semi-conducteur; un dispositif de détection de la conductance de ladite région ayant le type opposé de conductivité; une région de canal (14) de type appauvri dudit premier type de conductivité, formée sur ladite région (11) ayant le type opposé de conductivité; un isolant de grille (12) qui est formé sur la surface de ladite région de canal; et une électrode de grille (13) formée sur ledit isolant de grille; une partie dudit isolant de grille (12) ayant une épaisseur réduite et la partie de ladite région de canal (14) au-dessous de la partie d'épaisseur réduite dudit isolant de grille étant voisine de ladite région (11) ayant le type opposé de conductivité, sur un côté et étant entourée latéralement par les autres parties de ladite région de canal (14) dans ledit substrat semi-conducteur.

2. Dispositif à mémoire à semi-conducteurs selon la revendication 1, dans lequel les parties d'extrémité de ladite région de canal (14) sont en contact avec une ou plusieurs régions (15) ayant ledit premier type de conductivité et ayant une concentration d'impuretés relativement élevée, formées dans ledit substrat semi-conducteur.

3. Dispositif à mémoire à semi-conducteurs selon la revendication 1, dans lequel ladite région de canal (14) est couplée avec les parties dudit substrat semi-conducteur (10) ayant ledit premier type de conductivité.

4. Dispositif à mémoire à semi-conducteur selon la revendication 1, dans lequel chacune desdites cellules de mémoire comporte des régions (16, 17) de concentration d'impuretés relativement élevée, ayant ledit type opposé de conductivité, qui sont formées sur les deux côtés de ladite région (11) ayant le type opposé de conductivité et qui sont en contact ohmique avec ladite région (11) ayant le type opposé de conductivité.

5. Dispositif à mémoire à semi-conducteurs selon la revendication 4, dans lequel l'une desdites régions (16, 17) de concentration en impuretés relativement élevée ayant ledit type opposé de conductivité est connectée à une ligne de mots (WL) et une autre desdites régions (16, 17) de concentration en impuretés élevée ayant ledit type opposé de conductivité est connectée à une ligne de bits (BL) ladite électrode de grille (13) étant connectée à une ligne de données (DL) par laquelle est effectuée l'écriture des données dans la cellule de mémoire.

# Fig. 1

# Fig. 2

# Fig. 3A

$V_G = 0$

$Q_1$    $Q_2$

4 ~ p

1 ~ n    $V_S = 0$

# Fig. 3B

$V_G = 5 [V]$

$Q_1$    $Q_2$

$V_S = 0$

# Fig. 3C

$V_G = 5 [V]$

$Q_1$    $Q_2$

$x_{do}$

$V_S = 5 [V]$

# Fig. 3D

$V_G = 0$

$Q_1$    $Q_2$

p

n

$V_S = 5 [V]$    $x_{do}'$

# Fig. 3E

$V_G = 0$

$Q_1$    $Q_2$

$V_S = 0$

# Fig. 3F

$V_G = 0$

$Q_1$    $Q_2$

$V_S = 5$

# Fig. 3G

$V_G = 5 [V]$

$Q_1$    $Q_2$

p

n    $V_S = 5 [V]$

# Fig. 3H

$V_G = 0$

$Q_1$    $Q_2$

$x_{di}'$

$V_S = 5 [V]$

**Fig. 4**

**Fig. 5**

**Fig. 6**

# Fig. 7

DL

Q₁     C     Q₁

Q₀

BL       WL

# Fig. 8A

$V_G = 2.5$ [V]

Q₁      Q₂

p

n

p

$V_S = 5$ [V]

# Fig. 8B

$V_G = 2.5$ [V]

Q₁      Q₂

$V_S = 2.5$ [V]

# Fig. 8C

$V_G = 2.5$ [V]

Q₁      Q₂

$V_S = 0$

# Fig. 8D

$V_G = 2.5$ [V]

Q₁      Q₂

p

n

p

$V_S = 5$ [V]

# Fig. 8E

$V_G = 2.5$ [V]

Q₁      Q₂

$V_S = 2.5$ [V]

# Fig. 8F

$V_G = 2.5$ [V]

Q₁      Q₂

$V = 0$

4

## Fig. 9

## Fig. 10

# Fig. II